# EUROPEAN PATENT APPLICATION

(11) **EP 2 426 781 A1**
(43) Date of publication of application: **07.03.2012**
(21) Application number: 10769673.4
(22) Date of filing: 23.04.2010
(51) Int. Cl.: H01M 14/00, H01L 31/04

(54) **SEMICONDUCTOR ELECTRODE, SOLAR CELL USING SEMICONDUCTOR ELECTRODE, AND METHOD FOR PRODUCING SEMICONDUCTOR ELECTRODE**

(30) Priority: 30.04.2009 JP 2009111661; 30.04.2009 JP 2009111662; 30.04.2009 JP 2009111663
(71) Applicant: Bridgestone Corporation, Tokyo 104-8340 (JP)
(72) Inventor: YOSHIKAWA, Masato, Kodaira-shi, Tokyo 187-8531 (JP); MIYANO, Mari, Kodaira-shi, Tokyo 187-8531 (JP); OHNO, Shingo, Kodaira-shi, Tokyo 187-8531 (JP); NISHIDA, Mitsuhiro, Kodaira-shi, Tokyo 187-8531 (JP); SHINO, Osamu, Kodaira-shi, Tokyo 187-8531 (JP)
(74) Representative: Oxley, Robin John George
(86) International application number: PCT/JP2010/057217
(87) International publication number: WO 2010/125974

(57) **Abstract**

Disclosed is a semiconductor electrode (10) which comprises a transparent electrode (12) that is arranged on the surface of a light-transmitting substrate (11). The transparent electrode (12) is provided with a metal oxide layer (13) on a surface that is on the reverse side of a surface that is in contact with the substrate (11). The metal oxide layer (13) contains fine silicon particles (15), which absorb a specific wavelength among the wavelengths that are transmitted through the substrate (11), and fine metal oxide particles (14). The fine silicon particles (15) are arranged between the fine metal oxide particles (14).

## Description

### TECHNICAL FIELD

The present invention relates to a semiconductor electrode which converts light energy into electrical energy, a solar cell in which the semiconductor electrode is used, and a semiconductor electrode manufacturing method.

### BACKGROUND ART

In a related art solar cell, a substrate, such as crystalline silicon (Si), amorphous silicon or other element is used as an optical/electrical converter (see Patent Literature 1). In some related art solar cell, an oxide semiconductor sensitized with organic dyes is used as an optical/electrical converter instead of silicon (see Patent Literature 2). The optical/electrical converter converts light energy into electrical energy.

### CITATION LIST

### PATENT LITERATURES

[Patent Literature 1]: Japanese Patent Application Laid-open No. 61-54275
[Patent Literature 2]: Japanese Patent No. 2955646

### SUMMARY OF INVENTION

However, for example, the solar cell disclosed in Patent Literature 1 had many challenges to overcome, such as supply of silicon as a material, energy balance between energy and power generation capacity relating to a process of forming a bulk or thin-film substrate of, for example, crystalline silicon and amorphous silicon. The solar cell sensitized with dyes disclosed in Patent Literature 2 has challenges to overcome, such as improvement in durability and improvement in electric generation efficiency.

Therefore, in the field of solar cell, it is desired to develop a novel solar cell that is different from the related art solar cells, in addition to improve the related art solar cells described above.

Then, an object of the present invention is to provide a novel semiconductor electrode usable as an electrode used in a solar cell, a solar cell in which a semiconductor electrode is used, and a semiconductor electrode manufacturing method.

The present invention has following features to solve the above problems. A feature of the present invention is summarized as a semiconductor electrode comprising a transparent electrode disposed on a surface of a light transmissive substrate, wherein: a metal oxide layer is disposed on a surface of the transparent electrode opposite to a surface on which the transparent electrode is disposed on the substrate; the metal oxide layer includes fine silicon particles which absorb a specific wavelength among wavelengths of light which transmits the substrate, and fine metal oxide particles; and the fine silicon particles are disposed between the fine metal oxide particles.

Another feature of the present invention is summarized as that the fine silicon particles are formed to a predetermined particle diameter, by etching mixed powder containing the fine silicon particles in an etching solution which contains fluoric acid and an oxidizer

Another feature of the present invention is summarized as that H atoms adhered to surfaces of the fine silicon particles during the etching are replaced by an unsaturated hydrocarbon group.

Another feature of the present invention is summarized as that the unsaturated hydrocarbon group includes a hydrophilic group.

Another feature of the present invention is summarized as that the fine silicon particles having a plurality of types of particle diameters are used in a mixed manner.

A feature of the present invention is summarized as a solar cell comprising: a semiconductor electrode which is light transmissive and includes a light-incident surface through which light enters; a counter electrode disposed to face the semiconductor electrode; an electrolyte disposed in a cavity between the semiconductor electrode and the counter electrode; and a sealing material which seals the electrolyte disposed in the cavity, the solar cell converting light energy of light which enters the semiconductor electrode into electrical energy, wherein: the semiconductor electrode includes a transparent electrode disposed on a surface opposite to the light-incident surface side of the light transmissive substrate; the metal oxide layer is disposed on a surface of the transparent electrode opposite to a surface on which the transparent electrode is disposed on the substrate; the metal oxide layer includes fine silicon particles which absorb a specific wavelength among wavelengths of light which transmits the substrate, and fine metal oxide particles; and the fine silicon particles are disposed between the fine metal oxide particles.

Another feature of the present invention is summarized as that the fine silicon particles are formed to a predetermined particle diameter, by etching mixed powder containing the fine silicon particles in an etching solution which contains fluoric acid and an oxidizer,

Another feature of the present invention is summarized as that the solar cell includes at least one or more intermediate electrodes which include light transmissive transparent base material and the transparent electrode; the metal oxide layer is disposed on a surface of the intermediate electrode; the intermediate electrode is situated between the semiconductor electrode and the counter electrode; and a cavity between the semiconductor electrode and the intermediate electrode and a cavity between the intermediate electrode and the counter electrode are sealed by the sealing material with the electrolyte filled therein.

Another feature of the present invention is summarized as that the intermediate electrode includes: a light transmissive transparent base material; a first transparent electrode disposed on the light-incident surface of the transparent base material and including a catalyst electrode disposed on the side of the light-incident surface thereof; and a second transparent electrode disposed on a surface of the transparent base material opposite to the light-incident surface side.

Another feature of the present invention is summarized as that the fine silicon particles contained in the metal oxide layer disposed on the semiconductor electrode and the fine silicon particles contained in the metal oxide layer disposed on the intermediate electrode are different from each other in the particle diameter on a metal oxide layer basis.

A feature of the present invention is summarized as a semiconductor electrode manufacturing method, comprising: a step in which a mixture including a silicon source and a carbon source is baked under an inert atmosphere; a step in which production gas is extracted from the inert atmosphere and is cooled rapidly to obtain mixed powder which contains fine silicon particles; a step in which the fine silicon particles are extracted from the mixed powder; a step in which the transparent electrode is disposed on a surface of a light transmissive substrate and a metal oxide layer is disposed on a surface of the transparent electrode opposite to a surface on which the transparent electrode is disposed on the substrate; and a step in which the fine silicon particles are made to adhere to the metal oxide layer.

Another feature of the present invention is summarized as that the step in which the fine silicon particles are extracted includes a step in which the mixed powder is immersed and etched in an etching solution containing fluoric acid and oxidizer.

Another feature of the present invention is summarized as that in the step of etching, a particle diameter of the fine silicon particles is controlled by adjusting etching time.

Another feature of the present invention is summarized as that the step of extracting the fine silicon particles includes a termination step in which H atoms adhered to surfaces of the fine silicon particles during the etching are replaced by an unsaturated hydrocarbon group.

Another feature of the present invention is summarized as that the silicon source is ethyl silicate.

Another feature of the present invention is summarized as that the carbon source is phenol resin.

According to the present invention, it is possible to provide a novel semiconductor electrode usable as an electrode used in a solar cell, a solar cell in which a semiconductor electrode is used, and a manufacturing method of a semiconductor electrode usable in a solar cell.

### BRIEF EXPLANATION OF THE DRAWINGS

[Fig. 1] Fig. 1 is a configuration diagram of a single layer solar cell according to an embodiment of the present invention.
[Fig. 2] Fig. 2 is a configuration diagram of a tandem solar cell according to an embodiment of the present invention.
[Fig. 3] Fig. 3 is a configuration diagram illustrating an intermediate electrode according to an embodiment of the present invention.
[Fig. 4] Fig. 4 is flowchart illustrating mixed powder containing fine silicon particles.
[Fig. 5] Fig. 5 is a flowchart illustrating a semiconductor electrode manufacturing method.
[Fig. 6] Fig. 6 is a schematic diagram of manufacturing equipment used to prepare fine silicon particles.

### MODES FOR CARRYING OUT THE INVENTION

An embodiment of a semiconductor electrode and a solar cell according to the present invention will be described with reference to the drawings. Specifically, (1) structure of solar cell, (2) fine silicon particles and semiconductor electrode manufacturing method, (3) silicon source and carbon source, (4) fine silicon particles manufacturing equipment, (5) operation and effect and (6) other embodiments will be described.

In the following description of the drawings, the same or similar parts are denoted by the same or similar reference numerals. It should be noted that the drawings are schematic, and dimensional proportions and the like are different from their actual value.

Accordingly, specific dimension and the like should be determined with reference to the following description. In addition, it is a matter of course that dimensional relationships and dimensional proportions may be different from drawing to drawing.

### (1) Structure of Solar Cell

### (1-1) Single Layer Solar Cell

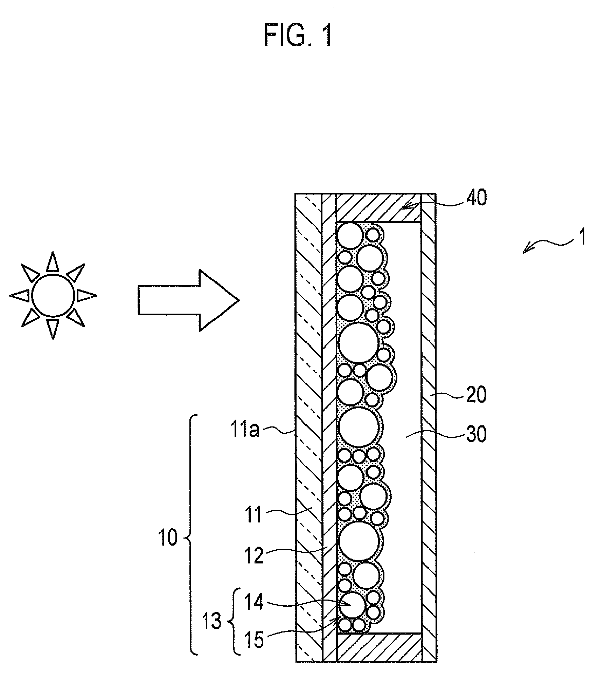

Fig. 1 is a configuration diagram of a single layer solar cell according to the present invention. A solar cell 1 includes a semiconductor electrode 10, a counter electrode 20, an electrolyte 30 and a sealing material 40. The semiconductor electrode 10 transmits light and includes a light-incident surface 11a through which light enters. The counter electrode 20 is disposed to face the semiconductor electrode 10. The electrolyte 30 is disposed in a cavity between the semiconductor electrode 10 and the counter electrode 20. The sealing material 40 seals the electrolyte 30 disposed in the cavity. The transparent electrode 12 and the counter electrode 20 are electrically connected by a terminal and an electric wire which are not illustrated. The solar cell 1 converts light energy of light which enters the semiconductor electrode 10 into electrical energy.

The semiconductor electrode 10 includes a substrate 11, a transparent electrode 12 and a metal oxide layer 13. The transparent electrode 12 is disposed on a light transmissive surface of the substrate 11. In particular, the transparent electrode 12 is disposed on a surface of the substrate 11, which transmits light and includes the light-incident surface 11a, opposite to the light-incident surface 11a.

The metal oxide layer 13 is disposed on a surface of the transparent electrode 12 opposite to a surface on which the transparent electrode 12 is disposed on the substrate 11. That is, the substrate 11 is disposed on one surface of the transparent electrode 12 on the side of the light-incident surface 11a and the metal oxide layer 13 is disposed on the other surface of the transparent electrode 12 on the side opposite to the one side. The transparent electrode 12 is located further near the light-incident surface 11a than the metal oxide layer 13. The metal oxide layer 13 includes fine metal oxide particles 14 and fine silicon particles 15.

The substrate 11 is a light transmissive substrate. The substrate 11 includes a light-incident surface 11a through which light enters. Examples of the material used for the substrate 11 include silicate glass and a plastic substrate. Various plastic substrates may be layered. A preferred material of the plastic substrate is, for example, resin having glass transition temperature of higher than 50 degrees C.

For example, a transparent resin substrate which includes the following resin as a principal component can be used: polyester resin, such as, polyethylene terephthalate, polycyclohexylene terephthalate and polyethylene naphthalate; polyamide resin, such as nylon 46, denatured nylon 6T, nylon MXD6 and polyphthalamide; ketone resin, such as polyphenylene sulfide and polythioether sulfine; sulfone resin, such as polyethersulfone and polyethernitrile; organic resin, such as polyethernitrile, polyarylate, polyetherimide, polyamidoimide, polycarbonate, polymethylmethacrylate, triacetyl cellulose, polystyrene and polyvinyl chloride. Among these, polycarbonate, polymethylmethacrylate, polyvinyl chloride, polystyrene, and polyethylene terephthalate are highly transparent and, at the same time, have a high birefringence value.

The transparent electrode 12 is a conductive thin metal-oxide layer including In₂O₃ and SnO₂. Examples of conductive metal oxide include In₂O₃:Sn (ITO), SnO₂:Sb (ATO), SnO₂:F (FTO), ZnO:aluminum (AZO), ZnO:F and CdSnO₄.

As fine metal oxide particles 14, one or two or more kinds of publicly known semiconductors, such as titanium oxide, zinc oxide, tungsten oxide, antimony oxide, niobium oxide, indium oxide, indium oxide, strontium titanate and cadmium sulphide can be used. Titanium oxide is preferably used from a stability point of view. As titanium oxide, various kinds of titanium oxide, such as anatase titanium dioxide, rutile titanium dioxide, amorphous titanium oxide, metatitanic acid and orthotitanic acid, or titanium hydroxide and hydrous titanium oxide are included.

The fine silicon particles 15 have characteristics to absorb a specific wavelength in accordance with the particle diameter among the wavelengths of light which transmits the substrate 11. That is, the fine silicon particles 15 are excited by the light having a specific wavelength and emit electrons. The fine silicon particles 15 are disposed between the fine metal oxide particles 14. The fine silicon particles 15 are disposed around the metal oxide layer 13. That is, the fine silicon particles 15 are disposed covering the fine metal oxide particles 14. Silicon particles having a plurality of particle diameters are mixed and used for the fine silicon particles 15. The particle diameter of the fine silicon particles 15 is within a predetermined size range. The predetermined size range is a range in which the fine silicon particles 15 are excited by light having a specific wavelength and emit electrons.

The fine silicon particles 15 may be prepared by immersing mixed powder of silicon dioxide and silicon in an etching solution. In the present embodiment, the particle diameter of the fine silicon particles 15 is determined by etching time in a process of etching. In the fine silicon particles 15, after the immersion of mixed powder of silicon dioxide and silicon in the etching solution, H atoms adhering to surfaces of the fine silicon particles 15 by etching may be replaced by an unsaturated hydrocarbon group which includes a hydrophilic group.

The fine metal oxide particles 14 and the fine silicon particles 15 may be dispersed in a binder and be applied to the transparent electrode 12. It is only necessary for the binder to allow the fine metal oxide particles 14 and the fine silicon particles 15 to be dispersed therein. Generally, polymer is used. Examples of the polymer include polyalkylene glycol (for example, polyethylene glycol), acrylic resin, polyester, polyurethane, epoxy resin, silicon resin, fluororesin, polyvinyl acetate, polyvinyl alcohol, polyacetal, polybutyral, petroleum resin, polystyrene and fiber resin.

The electrolyte 30 is, for example, a redox electrolyte, such as an I-/I₃- electrolyte, a Br-/Br₃- electrolyte and quinone/hydroquinone electrolyte. The I-/I₃- electrolyte can be obtained by mixing iodine ammonium salt and iodine. The electrolyte 30 may be liquid or solid. For example, the electrolyte 30 is a solid polymer electrolyte in which a liquid electrolyte or a liquid electrolyte is contained in a high molecular material.

As a liquid electrolyte solvent, an electrochemically inert electrolyte can be used. Examples of the liquid electrolyte include acetonitrile, propylene carbonate and ethylene carbonate.

The liquid electrolyte solvent may be conductive. Preferably, a liquid electrolyte solvent having catalyst activity to let a reduction reaction of an oxidation redox ion, such as an I3-ion, performed at a sufficient speed is used. Examples thereof include a platinum electrode, a conductive material with platinum plating or platinum vapor deposition on its surface, rhodium metal, ruthenium metal, ruthenium oxide and carbon.

The solar cell 1 is manufactured using each configuration described above. The metal oxide layer 13 is formed on a substrate 11 on which the transparent electrode 12 has been formed. In particular, a dispersion liquid is prepared in which a binder is added as needed to the fine metal oxide particles 14 and is applied onto the substrate 11, thereby preparing the fine metal oxide particles 14. After heating, pressurization and the like are performed as needed, the substrate 11 is immersed in the fine silicon particle dispersion liquid to let the fine silicon particles 15 adhere to surfaces of the fine metal oxide particles 14. Further heating or the like may be performed to enhance a chemical bond. As the counter electrode 20, a substrate is used which is constituted by a transparent base material and a catalyst transparent electrode (for example, a platinum electrode manufactured by vacuum deposition) disposed on a surface of the transparent base material on the side of the light-incident surface. The counter electrode 20 is connected, via a sealing material 40, to the substrate 11 on which the metal oxide layer 13 has been disposed. The electrolyte 30 is sealed in a cavity between the substrate 11 and the counter electrode 20.

In the solar cell 1 described above, the fine silicon particles 15 disposed around the fine metal oxide particles 14 absorb a specific wavelength in accordance with the particle diameter among wavelengths of light which transmits the substrate 11. That is, the fine silicon particles 15 are excited by the light having a specific wavelength and emit electrons. The emitted electrons are delivered to the transparent electrode 12 via the fine metal oxide particles 14. Holes remaining in the fine silicon particles 15 oxidize the electrolyte 30. For example, I- is oxidized to I₃- or Br- is oxidized to Br₃-. The oxidized iodide ion or bromide ion again receives electrons in the counter electrode 20 and reduced. In this manner, the electrons circulate between the two poles to thereby produce a solar cell.

### (1-2) Multi-Junction Type

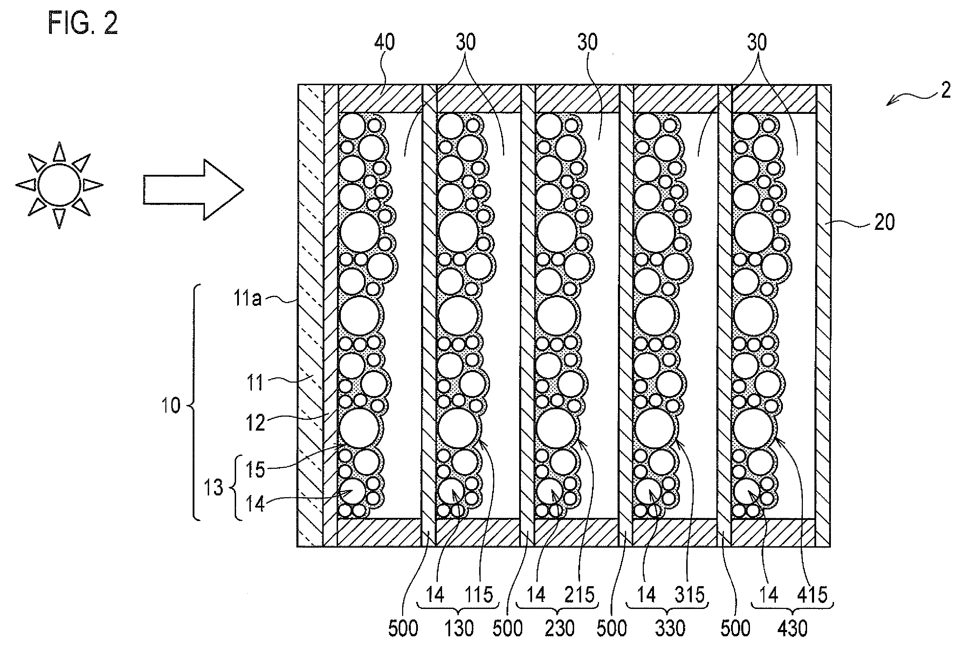

Fig. 2 is a configuration diagram of a tandem solar cell according to the present invention. A solar cell 2 includes a semiconductor electrode 10, a plurality of intermediate electrodes 500, a counter electrode 20, a electrolyte 30 and a sealing material 40. The substrate 11 transmits light and includes a light-incident surface 11a. As the counter electrode 20, a substrate is used in which a catalyst transparent electrode (for example, a platinum electrode manufactured by vacuum deposition) is disposed on a surface of the transparent electrode on the side of the light-incident surface. The solar cell 2 includes at least one or more intermediate electrodes 500. In the present embodiment, the solar cell 2 includes four intermediate electrodes 500.

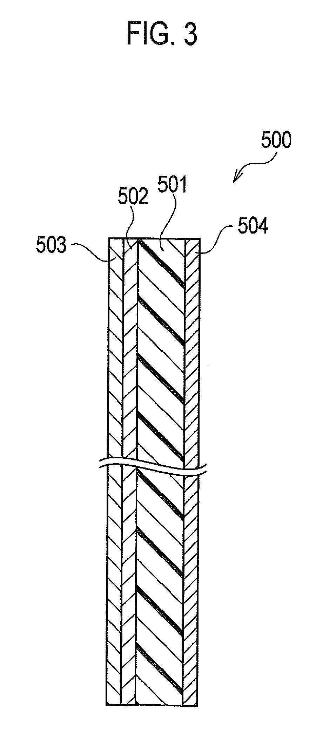

A configuration of the intermediate electrode 500 is illustrated in Fig. 3. The intermediate electrode 500 includes a transparent base material 501, a transparent electrode 502 and a transparent electrode 504. The transparent base material 501 transmits light. The transparent base material 501 can be formed by the same material as that of the substrate 11. The transparent electrode 502 is disposed on the light-incident surface of the transparent base material 501. A catalyst electrode 503 is formed on the surface of the light-incident side of the transparent electrode 502. Therefore, the catalyst electrode 503 is in contact with the electrolyte 30. Examples of the catalyst electrode 503 include a platinum electrode manufactured by vacuum deposition. The transparent electrode 504 is disposed on a surface opposite to the light-incident surface of the transparent base material 501. Therefore, the transparent electrode 504 is in contact with the metal oxide layer. The transparent electrode 502 and the transparent electrode 504 can be formed by the same material as that of the transparent electrode 12.

The intermediate electrode 500 is situated between the semiconductor electrode 10 and the counter electrode 20. A cavity between the semiconductor electrode 10 and the intermediate electrode 500 and a cavity between the intermediate electrode 500 and the counter electrode 20 are sealed by the sealing material 40 with the electrolyte 30 filled therein. As illustrated in Fig. 2, the solar cell 2 includes a plurality of intermediate electrodes 500. In this case, not only the cavity between the semiconductor electrode 10 and the intermediate electrode 500 and the cavity between the intermediate electrode 500 and the counter electrode 20, but a cavity between the intermediate electrode 500 and the intermediate electrode 500 are sealed by the sealing material 40 with the electrolyte 30 filled therein. Therefore, the electrolyte 30 is disposed in the cavity between the intermediate electrode 500 and the intermediate electrode 500. The sealing material 40 seals the electrolyte 30 in the cavity.

The metal oxide layer is disposed on a surface of the intermediate electrode 500. The metal oxide layer includes fine metal oxide particles 14 on which fine silicon particles are carried. As illustrated in Fig. 2, a metal oxide layer 130, a metal oxide layer 230, a metal oxide layer 330 and a metal oxide layer 430 are disposed on a surface of each intermediate electrode 500. The metal oxide layer 130 includes the fine metal oxide particles 14 and the fine silicon particles 115. The metal oxide layer 230 includes the fine metal oxide particles 14 and the fine silicon particles 215. The metal oxide layer 330 includes the fine metal oxide particles 14 and the fine silicon particles 315. The metal oxide layer 430 includes the fine metal oxide particles 14 and the fine silicon particles 415.

The fine silicon particles 15, the fine silicon particles 115, the fine silicon particles 215, the fine silicon particles 315 and the fine silicon particles 415 are what is called silicon nano dots. The same material as that of the fine silicon particles 15 can be used for the fine silicon particles 115, the fine silicon particles 215, the fine silicon particles 315 and the fine silicon particles 415. The particle diameters of the fine silicon particles are classified in advance on the predetermined size basis. That is, the fine silicon particles 15, the fine silicon particles 115, the fine silicon particles 215, the fine silicon particles 315 and the fine silicon particles 415 are different from one another in the particle diameter. Therefore, the fine silicon particles contained in the metal oxide layer disposed on the semiconductor electrode 10 and the fine silicon particles contained in the metal oxide layer disposed on the intermediate electrode 500 are different from each other in the particle diameter on a metal oxide layer basis. The fine silicon particles 15, the fine silicon particles 115, the fine silicon particles 215, the fine silicon particles 315 and the fine silicon particles 415 each absorb a specific wavelength which is different from one another among the wavelengths of light which transmits the substrate 11. For example, an absorption wavelength of the fine silicon particles 15 is 500 nm. The absorption wavelength of the fine silicon particles 115 is 600 nm. The absorption wavelength of the fine silicon particles 215 is 700 nm. The absorption wavelength of the fine silicon particles 315 is 900 nm. The absorption wavelength of the fine silicon particles 415 is 1100 nm.

### (2) Fine Silicon Particles and Semiconductor Electrode Manufacturing Method

### (2-1) Fine Silicon Particles

Processes of manufacturing the fine silicon particles 15, the fine silicon particles 115, the fine silicon particles 215, the fine silicon particles 315 and the fine silicon particles 415 described above will be described. Hereinafter, the fine silicon particles 15, the fine silicon particles 115, the fine silicon particles 215, the fine silicon particles 315 and the fine silicon particles 415 will be collectively referred to as the fine silicon particles or the fine silicon particles 15 appropriately.

In a process in which a silicon carbide sintered compact is manufactured, powder (silicon carbide powder) used in the formation of the silicon carbide sintered compact is manufactured. As an example of the silicon carbide powder manufacturing method, there is a method of baking a high-purity silicon carbide precursor (which will be referred to as a high-purity precursor). The high-purity precursor is a mixture obtained by homogeneously mixing a silicon source, a carbon source and a polymerization catalyst or crosslinking catalyst.

The fine silicon particles used in the present embodiment are separated from the gas produced as a sub-product in the process of baking the high-purity precursor. In the process of manufacturing the silicon carbide powder from the high-purity precursor, after the silicon source and the carbon source are mixed to each other, the mixture is heated at a temperature higher than 1600 degrees C under a non-oxidizing atmosphere and then silicon carbide (SiC) is extracted as powder.

That is, in the process of manufacturing the silicon carbide powder from the high-purity precursor, silicon carbide is prepared via the silicon monoxide (SiO) gas under an inert atmosphere (under a non-oxidizing atmosphere) by chemical reactions expressed by the following formulae (1) and (2). According to this method, silicon carbide is extracted as powder.

SiO₂+C->SiO+CO (1)

SiO+2C->SiC+CO (2)

The present inventors found that, when the gas extracted from the inert atmosphere after silicon carbide is prepared is cooled rapidly to a temperature below 1600 degrees C, a chemical reaction expressed by the following formula (3) occurs, and thereby the mixed powder containing silicon (Si) and silicon dioxide (SiO₂) is obtained. The fine silicon particles used in the present embodiment are contained in the mixed powder prepared in accordance with the formula (3).

2SiO->Si+SiO₂ (3)

As described above, the mixed powder containing the fine silicon particles illustrated as an embodiment of the present invention is to separate the fine silicon particles from the gas produced as a sub-product in the process of baking the high-purity precursor.

### (2-2) Fine Silicon Particles Manufacturing Method

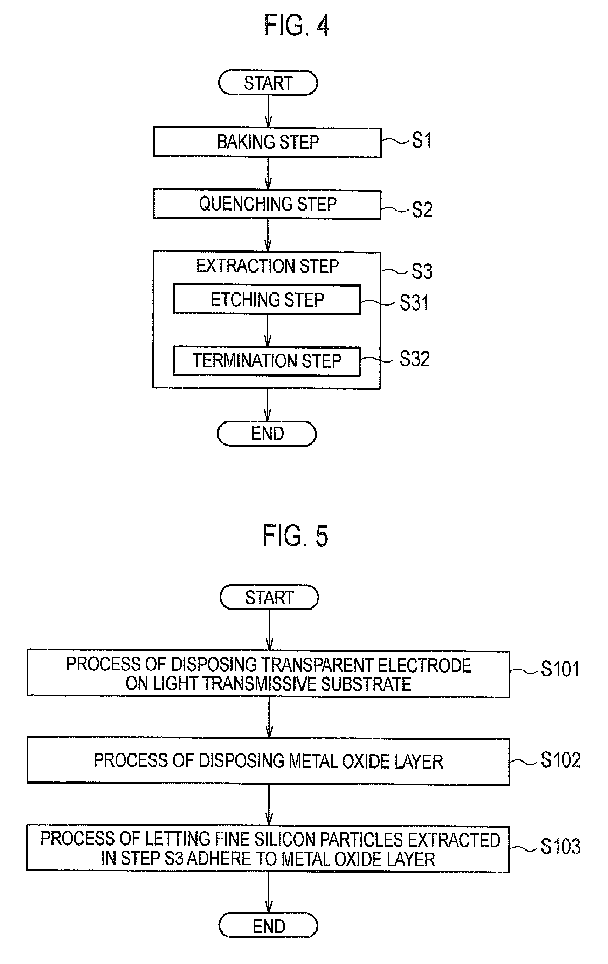

Fig. 4 is a flowchart illustrating the mixed powder containing fine silicon particles. As illustrated in Fig. 4, the mixed powder containing the fine silicon particles includes a baking step S1, a quenching step S2 and an extraction step S3.

The baking step S1 is a process to bake a mixture containing a silicon source and a carbon source under an inert atmosphere. In particular, the baking step S1 is a process to bake, under an inert atmosphere, a mixture (which will be referred to as a high-purity precursor) of a silicon source including at least one or more types of silicon compounds, a carbon source including at least one or more types of organic compounds which produces carbon when heated, and a polymerization catalyst or crosslinking catalyst. The silicon source is, for example, ethyl silicate. The carbon source is, for example, phenol resin. Details of the silicon source and the carbon source will be described below.

In the baking step S1, the mixture consisting of ethyl silicate as a silicon source, phenol resin as a carbon source and maleic acid as a polymerization catalyst is first heated at about 150 degrees C and hardened. A Si/C ratio is preferably 0.5 to 3.0. Next, a hardened material is heated at 800 to 1200 degrees C under a nitrogen or argon atmosphere for 0.5 to 2 hours. Then, the hardened material is heated at 1500 to 2000 degrees C under a nitrogen or argon atmosphere.

The quenching step S2 is a process to extract the production gas from the inert atmosphere and cool the extracted gas rapidly to obtain mixed powder containing fine silicon particles. In particular, the quenching step S2 is a process to extract, from the inert atmosphere, the gas produced during the baking of the high-purity precursor in the baking process and to cool the extracted gas rapidly. That is, the gas which is a sub-product of the reaction to produce silicon carbide by baking the high-purity precursor is extracted and cooled. If the gas as a sub-product is cooled under the condition described above, the mixed powder containing fine silicon particles is obtained.

In the quenching step S2, the production gas is extracted while being carried by the flow of argon gas. The production gas is cooled rapidly to the room temperature. Then, the mixed powder consisting of silicon (Si) and silica (SiO₂) is obtained from the production gas.

The extraction step S3 is a process to extract the fine silicon particles from the mixed powder. In particular, the extraction step S3 is a process to extract the fine silicon particles from the mixed powder obtained in the quenching step S2. Silicon is extracted from the mixed powder obtained in the quenching step S2. Then, silicon is extracted from the solvent and is dried. In this manner, the fine silicon particles with desired particle diameter are obtained.

In the present embodiment, the extraction step S3 includes an etching step S31 in which mixed powder is immersed and etched in an etching solution containing fluoric acid and oxidizer. Examples of the oxidizer include nitric acid (HNO3) and hydrogen peroxide (H2O2). A hydrophobic solvent, such as cyclohexane, and a micropolar solvent, such as 2-propanol, may be mixed to the etching solution in order to facilitate recovery of the silicon particles. The etching time is adjusted to obtain a desired light emission peak. Longer etching time tends to cause a shift of the light emission peak to a short wavelength side. Therefore, the particle diameter of the fine silicon particles can be controlled by adjusting etching time. As etching is performed until a desired light emission peak is obtained, the fine silicon particles luminescent material is extracted from the etching solution. The fine silicon particles luminescent material is separated from the etching solution by filtering the etching solution. The fine silicon particles having desired absorbency index are obtained by appropriately drying the separated fine silicon particles.

In the present embodiment, the extraction step S3 includes a termination step S32 in which the H atoms adhered to the surfaces of the fine silicon particles during the etching are replaced by an unsaturated hydrocarbon group.

When the etching step S31 is performed, the H atoms partially adhere to the surfaces of the fine silicon particles by fluoric acid used in the etching step, instead that silicon oxide which has covered the surfaces of the fine silicon particles are removed. Therefore, inconvenience in handling the fine silicon particles may be caused. For example, the fine silicon particles after the etching process become hydrophobic and easily flocculate in a solution.

Then, an unsaturated hydrocarbon group including a hydrophilic group is introduced on the surface of the fine silicon particles luminescent material. With the hydrosilylation reaction, the H atoms of Si-H, which is an active terminal of the fine silicon particles, are replaced by a termination material, such as a unsaturated hydrocarbon group which includes a hydrophilic group. Therefore, the flocculation stability of the fine silicon particles is increased and light absorption characteristics can be kept for a long time. In particular, the termination step S32 mixes the fine silicon particles into a solution to which the termination material is added. The reaction is promoted when the mixed solution is subject to heat or UV irradiation. In this manner, a fine silicon particle dispersion liquid is obtained.

It is only necessary for the unsaturated hydrocarbon group to include an unsaturated hydrocarbon group which includes a hydrophilic group. Examples thereof include 1-decene, tetra decene, 1-octene and styrene. A group produced from an isoprenoid compound which includes a hydrophilic group may be used. For example, monoterpenoid, such as linalool, is applicable. Unsaturated hydrocarbon group which includes hydrophilic group may be group produced from allyl compound which includes hydrophilic group. For example, allyl alcohol and eugenol are applicable.

### (2-3) Semiconductor Electrode Manufacturing Method

Fig. 5 is a flowchart illustrating a manufacturing method of the semiconductor electrode 10 according to the present embodiment. The manufacturing method of the semiconductor electrode 10 according to the present embodiment includes: a step S101 in which the transparent electrode 12 is disposed on a surface of the light transmissive substrate 11; a step S102 in which the metal oxide layer is disposed on a surface of the transparent electrode 12 opposite to a surface on which the transparent electrode 12 is disposed on the substrate 11; and a step S103 in which the fine silicon particles 15 are made to adhere to the metal oxide layer. In particular, in the step S103, the fine silicon particle dispersion liquid obtained through the baking step S1, the quenching step S2 and the extraction step S3 described above is made to be carried by or made to adhere to the metal oxide layer.

It should be noted that the order of the step S102 in which the metal oxide layer 13 is disposed on the substrate 11 on which the transparent electrode 12 has been disposed, and the baking step S1, the quenching step S2 and the extraction step S3 described above is not limited to that illustrated in Fig. 5. That is, it is possible to perform the processes to prepare the fine silicon particles 15 after the metal oxide layer 13 is disposed on the substrate 11 on which the transparent electrode 12 has been disposed; and it is possible to perform the step S102 in which the metal oxide layer 13 is disposed on the substrate 11 on which the transparent electrode 12 has been disposed after the fine silicon particles 15 are prepared.

### (3) Silicon Source and Carbon Source

### (3-1) Silicon Source

The silicon source containing the silicon compound described above is at least one type of a silicon-containing material selected from a group consisting of a liquid silicon compound and a solid silicon synthesized from a hydrolytic silicon compound. The liquid silicon source and the solid silicon source can be used together. If a plurality of types of silicon sources is used, at least one of them is a liquid silicon source.

The liquid silicon source is a polymer of alkoxysilane (mono-, di-, tri-, tetra-) and tetraalkoxysilane. Among alkoxysilanes, tetraalkoxysilane is preferably used. Examples thereof include methoxysilane, ethoxysilane, propoxysilane and butoxysilane. Ethoxysilane is preferably used from the viewpoint of easy handling of the source material.

Examples of the polymer of tetraalkoxysilane include a low molecular weight polymer (oligomer) with polymerization degree of about 2 to 15, and a silicate polymer with high polymerization degree and which is a liquid. Examples of the solid silicon source which can be used in combination with these include silicon oxide.

Silicon oxide includes SiO, silica gel (a colloidal hyperfine silica-containing liquid having a hydroxyl group, an alkoxyl group and the like therein), silicon dioxide (fine silica, quartz powder and the like).

Examples of the silicon-containing material include a silicon compound, such as a polymer of Group 1 obtained through trimethylation of a hydrolytic silicon compound, ester of a hydrolytic silicon compound and monovalent or polyvalent alcohol (for example, diol and triol) (for example, ethyl silicate synthesized through reaction of tetrachlorosilane and ethanol), and a reaction product other than ester obtained through a reaction of a hydrolytic silicon compound and an organic compound (for example, tetramethylsilane, dimethyldiphenylsilane and polydimethylsilane).

It is only necessary for the silicon solid synthesized from the hydrolytic silicon compound to react with carbon under a high-temperature non-oxidizing atmosphere (under an inert atmosphere) to produce silicon carbide. Preferred examples of silicon solid include amorphous silica fine powder obtained by hydrolyzing tetrachlorosilane.

The silicon source may be used alone or in combination of two or more types thereof. Among these silicon sources, an oligomer of tetraethoxysilane or a mixture of an oligomer of tetraethoxysilane and fine powder silica is preferably used from the viewpoint of homogeneity and easy handling.

Preferably, the silicon source is a material containing high-purity silicon. Here, high-purity represents that an impurity content of the silicon compound before forming a mixture is 20 ppm or lower. More preferably, the impurity content is 5 ppm or lower.

Preferred examples of the silicon source include a silicon source which produces silicon monoxide when heated. In particular, ethyl silicate is preferably used as the silicon source.

### (3-2) Carbon Source

A carbon-containing material used as a carbon source is preferably a high-purity organic compound which contains oxygen in its molecule and in which carbon remains when heated. The carbon source is a monomer, an oligomer and a polymer consisting of arbitrary one or two types of organic compounds which can be hardened through polymerization or crosslinking when exposed to heat, a catalyst or a crosslinking agent.

Preferred example of the carbon source include: hardening resin, such as phenol resin, furan resin, urea resin, epoxy resin, unsaturated polyester resin, polyimide resin and polyurethane resin; and various saccharides including monosaccharide, such as phenoxy resin and glucose, oligosaccharide, such as sucrose, and polysaccharide, such as cellulose and starch. Resol phenol resin or Novolak phenol resin having high actual carbon ratio and excellent workability are especially preferred.

Resol phenol resin useful in the present embodiment is prepared by letting univalent or divalent phenols, such as phenol, cresol, xylenol, resorcinol and bisphenol A react with aldehydes, such as formaldehyde, acetaldehyde and benzaldehyde under the existence of a catalyst (namely, ammonia or organic amine).

The carbon source is a liquid at the normal temperature. The carbon source is soluble to a solvent. The carbon source has thermoplastic or thermal melting properties and is softened or liquefied when heated. Therefore, the carbon source which is liquefied or is softened can be mixed to the silicon source homogenously. Resol phenol resin, Novolak phenol resin or the like can be preferably used as the carbon source. Resol phenol resin is used especially preferably.

### (3-3) Catalyst

The polymerization catalyst and the crosslinking catalyst used in the manufacture of high-purity silicon carbide powder can be selected appropriately in accordance with the carbon source. Examples thereof include acids, such as maleic acid, toluenesulfonic acid, toluenecarboxylic acid, acetic acid, oxalic acid and sulfuric acid if the carbon source is phenol resin or furan resin. Among these, toluenesulfonic acid is used preferably.

### (4) Fine Silicon Particles Manufacturing Equipment

### (4-1) Configuration of Manufacturing Equipment

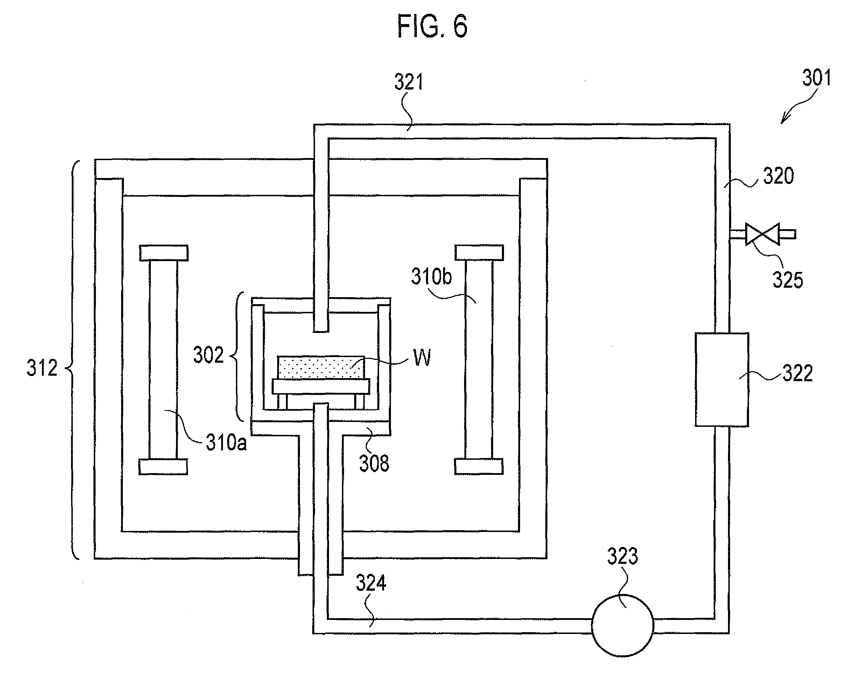

Fig. 6 illustrates a schematic diagram of the manufacturing equipment 301 used for the manufacture of the fine silicon particles. The manufacturing equipment 301 includes a heating vessel 302 and a stage 308 which supports the heating vessel 302. The heating vessel 302 contains a mixture (a high-purity precursor) W in which a silicon source, a carbon source and a polymerization catalyst or crosslinking catalyst are mixed together.

The manufacturing equipment 301 includes heating elements 310a and 310b. The heating elements 310a and 310b heat the mixture W in the heating vessel 302. The manufacturing equipment 301 includes a heat insulator 312 which covers the heating vessel 302 and the heating elements 310a and 310b.

The manufacturing equipment 301 includes a suction pipe 321 and a dust catcher 322. The suction pipe 321 is connected to an inside of the heating vessel 302. The suction pipe 321 sucks gas produced during the baking of the mixture W from the heating vessel 302 and guides the gas to the dust catcher 322. The dust catcher 322 collects the mixed powder obtained from the sucked gas.

The manufacturing equipment 301 includes a blower 323 and a supply pipe 324 which is connected to the heating vessel 302. The blower 323 supplies the supply pipe 324 with argon gas. The supply pipe 324 supplies the inside of the heating vessel 302 with argon gas. That is, argon gas circulates via the supply pipe 324, the heating vessel 302 and the suction pipe 321 of the manufacturing equipment 301 in this order. Gas produced from the mixture W is collected in the dust catcher 322 while being carried by the flow of argon gas.

The manufacturing equipment 301 includes a solenoid valve 325. The solenoid valve 325 is provided at the suction pipe 321, and is automatically opened and closed to keep the predetermined internal pressure of the heating vessel 302.

### (4-2) Operation of Manufacturing Equipment

The manufacturing equipment 301 lets the heating elements 310a and 310b generate heat, and heats the heating vessel 302 under a predetermined temperature condition. At this time, inside of the heating vessel 302 is kept in a nitrogen atmosphere or an argon atmosphere. The above process corresponds to the baking step S1.

Subsequently, the manufacturing equipment 301 lets the blower 323 operate. At this time, when the blower 323 is started, the gas generated from the mixture W is carried on the flow of argon gas supplied from the blower 323, and is extracted into the dust catcher 322 from the inside of the heating vessel 302 via the suction pipe 321. Since the outside of the heat insulator 312 is at the room temperature, the gas carried on the flow of argon gas and guided outside the heating vessel 302 is rapidly cooled to the room temperature. At this time, complex of silicon (Si) and silicon dioxide (SiO₂) is obtained from gas. The obtained complex is collected in the dust catcher 322. The above process corresponds to the quenching step S2.

Powder of the complex (which is referred to as "mixed powder") collected in the dust catcher 322 is subject to wet grinding together with an organic solvent in, for example, a planetary ball mill (not illustrated Fig. 6). The above process corresponds to the extraction step S3.

### (5) Operation and Effect

The semiconductor electrode 10 includes the transparent electrode 12 disposed on a surface of the light transmissive substrate 11. The metal oxide layer 13 is disposed on a surface of the transparent electrode 12 opposite to a surface on which the transparent electrode 12 is disposed on the substrate 11. The metal oxide layer 13 includes the fine silicon particles 15 and the fine metal oxide particles 14. The fine silicon particles 15 absorb a specific wavelength among wavelengths of light which transmits the substrate 11. The fine silicon particles 15 are disposed between the fine metal oxide particles 14.

In the solar cell 1, the fine silicon particles 15 disposed in the metal oxide layer 13 absorb a specific wavelength among wavelengths of light which transmits the substrate 11 and emit electrons. Therefore, the semiconductor electrode 10 can extract light energy of a specific wavelength among wavelengths of light which transmits the substrate 11 as electrical energy.

In the present embodiment, the fine silicon particles 15 having a plurality of types of particle diameters are mixed and used. Since the fine silicon particles 15 absorb a specific wavelength in accordance with the particle diameters, a wavelength range of light which can be extracted as electrical energy can be extended by using, in a mixed manner, the fine silicon particles 15 having a plurality of types of particle diameters. That is, a greater wavelength range can be used among wavelengths of visible light by using the fine silicon particles having a plurality of particle diameters.

The solar cell 2 includes at least one intermediate electrodes 500 which includes the light transmissive transparent base material 501, the transparent electrode 502 and the transparent electrode 504. The metal oxide layer 130, the metal oxide layer 230, the metal oxide layer 330 and the metal oxide layer 430 are disposed on the surfaces of the intermediate electrodes 500. The intermediate electrodes 500 are situated between the semiconductor electrode 10 and the counter electrode 20. A cavity between the semiconductor electrode 10 and the intermediate electrode 500 and a cavity between the intermediate electrode 500 and the counter electrode 20 are sealed by the sealing material 40 with the electrolyte 30 filled therein. Therefore, since not only the fine silicon particles 15 but the fine silicon particles 115, the fine silicon particles 215, the fine silicon particles 315 and the fine silicon particles 415 absorb a specific wavelength and emit electrons by this, a greater amount of light energy can be extracted as electrical energy.

In the solar cell 2, the fine silicon particles contained in the metal oxide layer 13 disposed on the semiconductor electrode 10 and the fine silicon particles contained in the metal oxide layer disposed on the intermediate electrode 500 are different from each other in the particle diameter on a metal oxide layer basis. Therefore, the wavelength range of light which can be extracted as electrical energy can be extended.

The manufacturing method of the semiconductor electrode 10 according to the present embodiment includes: a step S1 in which a mixture including a silicon source and a carbon source is baked under an inert atmosphere; a step S2 in which production gas is extracted from the inert atmosphere and is cooled rapidly to obtain mixed powder which contains fine silicon particles 15; a step S3 in which the fine silicon particles 15 are extracted from the mixed powder; a step in which the transparent electrode is disposed on a surface of a light transmissive substrate and a metal oxide layer is disposed on a surface of the transparent electrode opposite to a surface on which the transparent electrode is disposed on the substrate; and a step S103 in which the fine silicon particles 15 are made to adhere to the metal oxide layer. In this manner, the semiconductor electrode 10 according to the present embodiment can be manufactured.

In the present embodiment, since the mixed powder containing the fine silicon particles 15 is etched in an etching solution which contains fluoric acid and an oxidizer, the fine silicon particles 15 are formed to a predetermined particle diameter. The fine silicon particles of predetermined particle diameter can be obtained easily by etching in the etching solution.

In the present embodiment, in the etching step S31, the particle diameter of the fine silicon particles 15 is controlled by adjusting etching time. Therefore, since the fine silicon particles 15 absorb an arbitrary wavelength and emit electrons, a greater amount of light energy can be extracted as electrical energy.

In the present embodiment, the H atoms adhered to the surfaces of the fine silicon particles 15 during the etching are replaced by an unsaturated hydrocarbon group. Therefore, the fine silicon particles 15 with favorable handling properties can be used. Since flocculation stability of the fine silicon particles is enhanced, light absorption characteristics can be maintained for a long time.

As described above, the semiconductor electrode 10 according to the present embodiment can be used as an electrode used in a solar cell.

### (6) Other Embodiments

As described above, although the present invention has been described with reference to the embodiments, it should not be understood that the discussion and the drawings which constitute a part of the present invention is restrictive to the invention. Various alternatives, examples and operational techniques will be apparent to a person skilled in the art from this disclosure. As described above, it is of course that the present invention includes various embodiments or the like that are not described herein. Accordingly, the technical scope of the present invention is defined only by the matter to define the invention related to the claims that is reasonable from the above description.

Japanese patent application No. 2009-111661 (filed April 30, 2009), Japanese patent application No. 2009-111662 (filed April 30, 2009) and Japanese patent application No. 2009-111663 (filed April 30, 2009) are hereby incorporated by reference in their entirety.

### Industrial Applicability

As described above, the semiconductor electrode, the solar cell in which the semiconductor electrode is used, and a semiconductor electrode manufacturing method according to the present invention are useful in the field of manufacturing the solar cell because they can provide a novel semiconductor electrode usable as an electrode used in a solar cell, a solar cell in which a semiconductor electrode is used, and a manufacturing method of a semiconductor electrode usable in a solar cell.

### Reference Numeral

1··· solar cell, 2··· solar cell, 10··· semiconductor electrode, 11···substrate, 11a ··· light-incident surface, 12,502,504··· transparent electrode, 13,130,230,330,430 ···metal oxide layer, 14···metal oxide particle, 15,115,215,315,415···silicon particle, 20···counter electrode, 30··· electrolyte, 40··· sealing material, 301···manufacturing equipment, 302 ···heating vessel, 308···stage, 310a,310b···heating element, 312···heat insulator, 321···suction pipe, 322···dust catcher, 323···blower, 324··· supply pipe, 325···solenoid valve, 500···intermediate electrode, 501··· transparent base material, 503··· catalyst electrode

## Claims

1. A semiconductor electrode comprising a transparent electrode disposed on a surface of a light transmissive substrate, wherein:
a metal oxide layer is disposed on a surface of the transparent electrode opposite to a surface on which the transparent electrode is disposed on the substrate;
the metal oxide layer includes fine silicon particles which absorb a specific wavelength among wavelengths of light which transmits the substrate, and fine metal oxide particles; and
the fine silicon particles are disposed between the fine metal oxide particles.

2. The semiconductor electrode according to claim 1, wherein, the fine silicon particles are formed to a predetermined particle diameter, by etching mixed powder containing the fine silicon particles in an etching solution which contains fluoric acid and an oxidizer.

3. The semiconductor electrode according to claim 2, wherein H atoms adhered to surfaces of the fine silicon particles during the etching are replaced by an unsaturated hydrocarbon group.

4. The semiconductor electrode according to claim 3, wherein the unsaturated hydrocarbon group includes a hydrophilic group.

5. The semiconductor electrode according to any one of claims 1 to 4, wherein the fine silicon particles having a plurality of types of particle diameters are used in a mixed manner.

6. A solar cell comprising:
a semiconductor electrode which is light transmissive and includes a light-incident surface through which light enters;
a counter electrode disposed to face the semiconductor electrode;
an electrolyte disposed in a cavity between the semiconductor electrode and the counter electrode; and
a sealing material which seals the electrolyte disposed in the cavity,
the solar cell converting light energy of light which enters the semiconductor electrode into electrical energy,
wherein:
the semiconductor electrode includes a transparent electrode disposed on a surface opposite to the light-incident surface side of the light transmissive substrate;
the metal oxide layer is disposed on a surface of the transparent electrode opposite to a surface on which the transparent electrode is disposed on the substrate;
the metal oxide layer includes fine silicon particles which absorb a specific wavelength among wavelengths of light which transmits the substrate, and fine metal oxide particles; and
the fine silicon particles are disposed between the fine metal oxide particles.

7. The solar cell according to claim 6, wherein, the fine silicon particles are formed to a predetermined particle diameter, by etching mixed powder containing the fine silicon particles in an etching solution which contains fluoric acid and an oxidizer.

8. The solar cell according to claim 7, wherein H atoms adhered to surfaces of the fine silicon particles during the etching are replaced by an unsaturated hydrocarbon group.

9. The solar cell according to claim 8, wherein the unsaturated hydrocarbon group includes a hydrophilic group.

10. The solar cell according to any one of claims 6 to 9, wherein the fine silicon particles having a plurality of types of particle diameters are used in a mixed manner.

11. The solar cell according to any one of claims 6 to 10, wherein:
the solar cell includes at least one or more intermediate electrodes which include light transmissive transparent base material and the transparent electrode;
the metal oxide layer is disposed on a surface of the intermediate electrode;
the intermediate electrode is situated between the semiconductor electrode and the counter electrode; and
a cavity between the semiconductor electrode and the intermediate electrode and a cavity between the intermediate electrode and the counter electrode are sealed by the sealing material with the electrolyte filled therein.

12. The solar cell according to claim 11, wherein, the intermediate electrode includes:
a light transmissive transparent base material;
a first transparent electrode disposed on the light-incident surface of the transparent base material and including a catalyst electrode disposed on the side of the light-incident surface thereof; and
a second transparent electrode disposed on a surface of the transparent base material opposite to the light-incident surface side.

13. The solar cell according to claim 11 or 12, wherein the fine silicon particles contained in the metal oxide layer disposed on the semiconductor electrode and the fine silicon particles contained in the metal oxide layer disposed on the intermediate electrode are different from each other in the particle diameter on a metal oxide layer basis.

14. A semiconductor electrode manufacturing method, comprising:
a step in which a mixture including a silicon source and a carbon source is baked under an inert atmosphere;
a step in which production gas is extracted from the inert atmosphere and is cooled rapidly to obtain mixed powder which contains fine silicon particles;
a step in which the fine silicon particles are extracted from the mixed powder;
a step in which the transparent electrode is disposed on a surface of a light transmissive substrate and a metal oxide layer is disposed on a surface of the transparent electrode opposite to a surface on which the transparent electrode is disposed on the substrate; and
a step in which the fine silicon particles are made to adhere to the metal oxide layer.

15. The semiconductor electrode manufacturing method according to claim 14, wherein the step in which the fine silicon particles are extracted includes a step in which the mixed powder is immersed and etched in an etching solution containing fluoric acid and oxidizer.

16. The semiconductor electrode manufacturing method according to claim 15, wherein, in the step of etching, a particle diameter of the fine silicon particles is controlled by adjusting etching time.

17. The semiconductor electrode manufacturing method according to claim 15 or 16, wherein the step of extracting the fine silicon particles includes a termination step in which H atoms adhered to surfaces of the fine silicon particles during the etching are replaced by an unsaturated hydrocarbon group.

18. The semiconductor electrode manufacturing method according to claim 17, wherein the unsaturated hydrocarbon group includes a hydrophilic group.

19. The semiconductor electrode manufacturing method according to any one of claims 14 to 18, wherein the silicon source is ethyl silicate.

20. The semiconductor electrode manufacturing method according to any one of claims 14 to 18, wherein the carbon source is phenol resin.
